# EUROPEAN PATENT APPLICATION

(11) **EP 4 844 413 A1**
(43) Date of publication of application: **25.11.2026**
(21) Application number: 26176838.6
(22) Date of filing: 06.05.2026
(51) Int. Cl.: G01R 1/20, G01R 19/00, G01R 19/25, G01R 35/00

(54) **CURRENT SENSING CIRCUIT AND CORRESPONDING METHOD**

(30) Priority: 21.05.2025 IT 202500011542
(71) Applicant: STMicroelectronics International N.V., 1228 Plan-les-Ouates, Geneva (CH)
(72) Inventor: FABIANO, Sergio, 96100 Siracusa (IT); MARLETTA, Vincenzo, 95037 San Giovanni La Punta (CT) (IT); WEBER, Stephan, 83052 Bruckmuehl (DE)
(74) Representative: Buzzi, Notaro & Antonielli d'Oulx S.p.A.

(57) **Abstract**

It is disclosed herein a current sensing circuit (100) for measuring an input current (IS) by providing a digital representation (CS) thereof, the current sensing circuit (100) comprising:
- a transimpedance amplifier (120) comprising a measurement resistance (122) the value of which is subject to a change in time (DR), and configured to receive as input the input current (IS) and to provide at respective output terminals a voltage (VS) proportional to the input current (IS);
- a replica resistance (124) having a resistance value substantially equal to the initial (T0) value of the measurement resistance (122), and subject to the same change in time (DR) of the measurement resistance (122);
- a reference resistance (128) having a resistance value with long-term stability;
- a reference voltage pad (VR) for receiving a reference voltage (VR);
- a first analog-to-digital converter (112) coupled to the transimpedance amplifier (120), and configured to acquire the voltage (VS) and to convert it into a corresponding digital output code (DS); and
- a control unit (114) coupled to the first analog-to-digital converter (112), and configured to output a calibrated measurement value (CS) obtained by applying a correction (CP) to the digital code (DS);
wherein said correction (CP) is determined by the control unit (114) as a ratio of a baseline (VB) determined at a first time instant (T0) and of a calibration value (VC) determined at a subsequent time instant (TN), the baseline (VB) and the calibration value (VC) being determined on the basis of the values of the replica resistance (124) and of the external reference resistance (128).

## Description

### Technical field

The present disclosure relates to current sensing techniques.

### Technological background

Mixed-signal circuits require precise analog performance despite inherent device tolerances. While voltage sensing, e.g., by scaling or amplification, can achieve high accuracy through feedback and digital trimming techniques due to its dimensionless gain e.g., A = dV_{OUT}/dV_{IN}, where V_{IN} corresponds to a voltage to be monitored and V_{OUT} corresponds to an output voltage provided by the voltage sensor, current sensing with voltage output presents unique challenges due to element ratios. Specifically, in current sensors an inherent key limitation arises from the transimpedance gain, Z = dV_{OUT}/dI_{IN}, where I_{IN} corresponds to a current to be monitored and V_{OUT} corresponds to an output voltage provided by the current sensor. In fact, even when implementing standard feedback techniques to match the transimpedance gain Z to the feedback resistance, the feedback loop resistors exhibit significant variations across process, temperature, and time domains. These variations manifest through temperature coefficient deviations, long-term aging effects, and initial process spread.

Modern signal processing chains typically incorporate high-resolution analog-to-digital converters (ADCs), making the stability of the transimpedance gain Z critical for system accuracy. However, even with one-time digital trimming, the achievable analog accuracy is usually limited to approximately 5% over the device lifetime due to the feedback resistance variations.

For high-precision measurements in current sensors and other integrated circuit blocks where resistors affect the transfer function, compensation methods for temperature drift and aging effects are thus essential. These methods require continuous tracking of resistance variations combined with active compensation mechanisms to maintain output accuracy through periodic trimming or calibration procedures.

The current state-of-the-art mainly relies on single-point calibration approaches, where correction factors are determined during device characterization either before or after soldering. Specifically, current compensation methods employ two main approaches comprising a periodic system recalibration performed at fixed intervals to address aging drift, and temperature drift compensation based on prior sensor characterization data.

These approaches have fundamental limitations, as they cannot compensate for resistance drift occurring during the operational lifetime of the device. In fact, periodic recalibration requires system interruption, which is often impractical for embedded applications where continuous operation is necessary. Further, implementation of recalibration capability requires additional switching circuits, introducing new error sources into the measurement path.

On the other hand, temperature compensation schemes utilizing initial characterization data fail to track actual resistance drift patterns during operation, leading to measurement inaccuracies.

Therefore, these technical constraints establish the need for improved compensation methods that maintain measurement accuracy without operational interruption or dependence on historical characterization data.

### Object and summary

An object of the solutions described herein is to contribute in addressing the issues discussed in the foregoing.

According to one or more embodiments, one or more of the above objects are achieved by a circuit having the distinctive elements set forth specifically in the ensuing claims. Embodiments moreover concern a corresponding method.

The scope of protection is defined in the appended claims, which form an integral part of the technical teaching of the description provided herein.

As mentioned before, solutions as described herein relate to a current sensing circuit for measuring an input current by providing a digital representation thereof, the current sensing circuit comprising a transimpedance amplifier comprising a measurement resistance the value of which is subject to a change in time, and configured to receive as input the input current and to provide at respective output terminals a voltage proportional to the input current; a replica resistance having a resistance value substantially equal to the initial value of the measurement resistance, and subject to the same change in time of the measurement resistance; a reference resistance having a resistance value with long-term stability; a reference voltage pad for receiving a reference voltage; a first analog-to-digital converter coupled to the transimpedance amplifier, and configured to acquire the voltage and to convert it into a corresponding digital output code; and a control unit coupled to the first analog-to-digital converter, and configured to output a calibrated measurement value obtained by applying a correction to the digital code.

In particular, the correction is determined by the control unit as a ratio of a baseline determined at a first time instant and of a calibration value determined at a subsequent time instant, the baseline and the calibration value being determined on the basis of the values of the replica resistance and of the external reference resistance.

Further, solutions as described herein relate to a method for measuring a current by means of the aforementioned current sensing circuit, comprising performing the steps of acquiring at a first time instant through an analog-to-digital converter a calibration baseline value indicative of a ratio between the replica resistance and the reference resistance, associating to the calibration baseline value a timestamp value indicative of the time at which the calibration is performed, and storing said calibration baseline value and said timestamp value in a non-volatile memory; successively determining, at a subsequent time instant, whether a new calibration is required on the basis of said timestamp value; in response to determining that a new calibration is required, performing a further calibration measurement, updating the value of the timestamp to the time at which the new calibration is carried out, and computing the value of a calibration parameter as a ratio of said calibration baseline and of the calibration measurement; measuring the input current through the transimpedance amplifier and the analog-to-digital converter coupled thereto, returning a digital code indicative of the measured input current; and applying in the control unit a correction to the digital code based on the calibration parameter stored in the non-volatile memory, returning a calibrated measurement.

### Brief description of the drawings

Embodiments of the present disclosure will now be described with reference to the annexed drawings, which are provided purely by way of non-limiting example and in which:
- Figure 1 shows a schematic diagram of an embodiment of current sensing circuit according to solutions as described herein;
- Figure 2 shows a detailed schematic diagram of an embodiment of current sensing circuit according to solution as described herein;
- Figure 3 shows a portion of integrated circuit comprising interdigitated resistors;
- Figure 4 shows a flowchart representing an embodiment of a method for performing calibration in the current sensing circuit of Figure 2;
- Figure 5 shows a detailed schematic diagram of a further embodiment of current sensing circuit according to solutions as described herein;
- Figure 6 shows a flowchart representing an embodiment of a method for performing calibration in the current sensing circuit of Figure 5; and
- Figure 7 shows a schematic diagram of a further embodiment of current sensing circuit according to solutions as described herein.

### Detailed description

In the following description, numerous specific details are given to provide a thorough understanding of embodiments. The embodiments can be practiced without one or several specific details, or with other methods, components, materials, etc. In other instances, well-known structures, materials, or operations are not shown or described in detail to avoid obscuring aspects of the embodiments.

Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The headings provided herein are for convenience only and do not interpret the scope or meaning of the embodiments.

As mentioned before, various embodiments of the present disclosure provide solutions for compensating drifting of resistors in Accurate Current Sensors (ACS) due to temperature, other environment related effects, and/or aging, by applying a correction to the current measurement performed by the Accurate Current Sensor in digital domain.

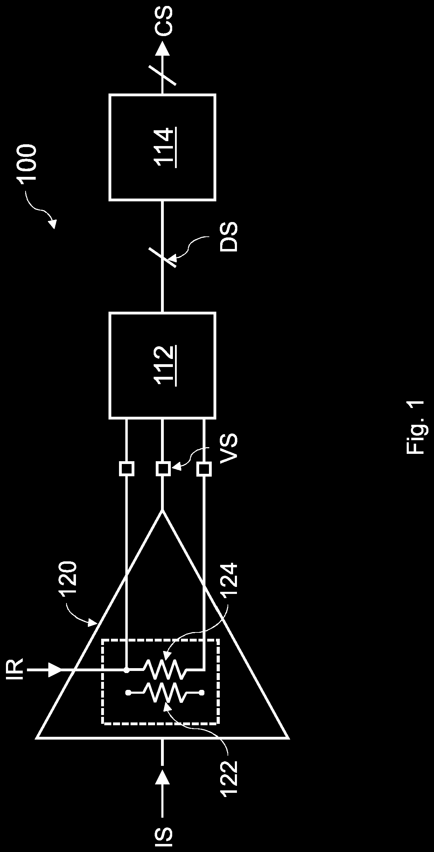

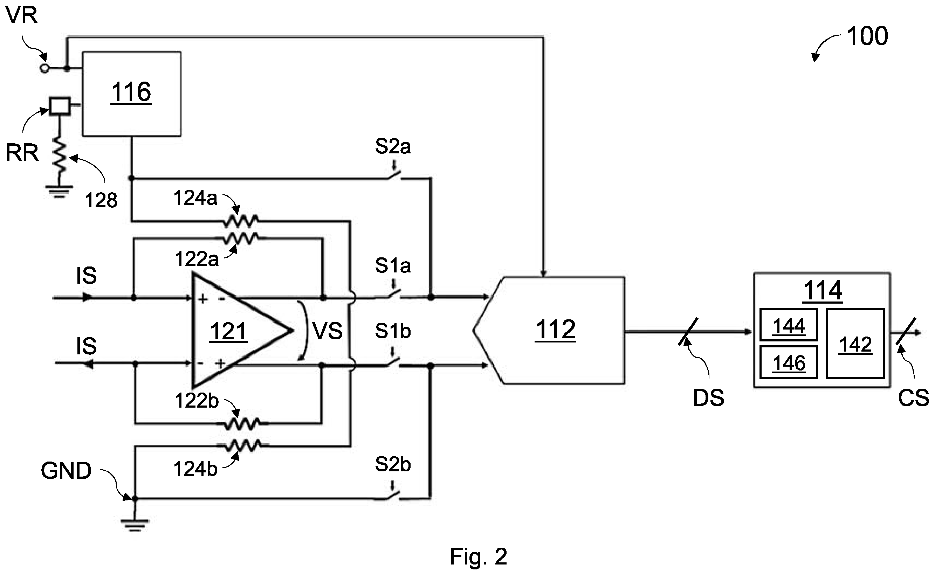

In this regard, Figure 1 is illustrative of a block diagram of a current sensing circuit 100 according to solutions as proposed herein. As illustrated, the current sensing circuit 100 comprises a transimpedance amplifier 120, an Analog-to-Digital converter (ADC) 112, and a control unit 114. As described in greater detail with respect to Figure 2, the control unit 114 may comprise a processor 142, a system memory 144, and a non-volatile memory 146. In various embodiments, the control unit 114 is configured to acquire digital values from the ADC circuit 112, and to perform computations for applying corrections to current measurements. To this end, the non-volatile memory 146 comprises software code which is executed by means of the processor 142 and of the system memory 144.

The transimpedance amplifier 120 has an input port for receiving an input current IS, and an output port through which an output voltage VS, proportional to the input current IS through a transimpedance value Z, is outputted to the ADC 112 having an input terminal coupled thereto.

In order to measure the input current IS, the transimpedance amplifier 120 comprises a measuring resistance 122, which is traversed by the input current IS and has a resistance value R122. As anticipated, such measuring resistance 122 is subject to drift in time due to environmental conditions and/or aging, referred at resistance drift DR hereinafter, thus affecting the accuracy of measurements. Hence, the output voltage VS outputted by the transimpedance amplifier 120, which is indicative of the voltage across the sensing resistance 122, is likewise affected by such drift in time DR of the measuring resistance 122.

In various embodiments, the current sensing circuit 100 comprises a replica resistance 124 having a resistance value, indicated as R124, matched to the measurement resistance 122, and serves the purpose of tracking the resistance drift DR over the time. To this end, a reference current IR is let flow through the replica resistance 124. As illustrated, the terminals of the replica resistance 124 are coupled to the ADC 112 in order to detect the voltage between them.

In turn, the ADC 112 receives as input, at one or more respective input terminals, either the output voltage VS of the transimpedance amplifier 120, or the voltage across the replica resistance 124, namely equal to R124 * IR, and outputs a corresponding digital code at a respective output terminal.

To this end, the input terminals of the ADC 112 can be coupled either to the output terminal of the transimpedance amplifier 120, or to the terminals of the replica resistance 124. For example, such terminals may be coupled to the ADC 112 by means of one or more switches. Alternatively, the ADC circuit 112 may comprise more than one input port, as to allow the simultaneous coupling of the transimpedance amplifier 120 and of the replica resistance 124.

In particular, when the ADC circuit 112 has its input port coupled to the transimpedance amplifier 120, it outputs a digital output code DS corresponding to the digital representation of the voltage VS outputted by the transimpedance amplifier 120. Hence, the digital output code DS corresponds to a digital representation of the measured input current IS.

On the other hand, when the ADC circuit 112 is employed for acquiring the voltage V124 across the replica resistance 124 i.e., R124 * IR, the ADC circuit 112 outputs a corresponding digital value D4 indicative of the voltage measured, which is subsequently processed by the control unit 114 for determining a calibration baseline value VB or as a calibration value VC.

The control unit 114 receives the digital code DS at a respective input terminal, and stores it for performing subsequent processing steps. In particular, the control unit 114 may receive as input a digital code DS indicative either of the output voltage VS of the transimpedance amplifier 120, or the digital code D4 indicative of the voltage across the replica resistance 124. In the first case, the digital code DS is indicative of the measured current IS, whereas the digital code D4 corresponding to the voltage V124 = R124 * IR across the replica resistance 124 is employed for determining one or more corrections for calibrating the current measurement, as it will be made clearer in the following.

Once the calibration is performed and the corrections are applied, the control unit 114 outputs a calibrated measurement CS, which is represented as digital value, thus returns a calibrated current measurement.

Figure 2 is illustrative of a detailed schematics of a possible embodiment of the current sensing circuit 100 illustrated in Figure 1.

As illustrated, the transimpedance amplifier 120 comprises a differential amplifier 121, which in turn comprises a positive input terminal, a negative input terminal, a positive output terminal, and a negative output terminal. The positive input terminal of the differential amplifier 121 is coupled to the negative output terminal through a first measurement resistance 122a, whereas the negative input terminal is coupled to the positive output terminal through a second measurement resistance 122b. The voltage difference between the positive output terminal and the negative output terminal of the differential amplifier 121 is the output voltage VS.

The positive output terminal and the negative output terminal of the differential amplifier 121 are selectively couplable to the ADC 112 through a first pair of switches S1, which is opened or closed under the control of the control unit 114 and comprises a first switch S1a coupling the negative output terminal of the differential amplifier 121 to the ADC 112, and a second switch S1b coupling the positive output terminal of the differential amplifier 121 to the ADC 112. Hence, the negative output terminal and the positive output terminal of the transimpedance amplifier 120 are connected to an input port of the ADC 112 through the first pair of switches S1, when the first pair of switches S1 is closed.

The current sensing circuit 100 further comprises a reference current generator 116, which is configured to provide the fixed reference current IR on the basis of a reference voltage VR, and of an external reference resistance 128. The external reference resistance 128 has a high long-term stability, and is coupled to the reference current generator 116 through a dedicated connection pad RR.

In various embodiments, the reference resistance 128 can be chosen in such a way that it has a resistance value substantially equal to the measurement resistance 122 and to the replica resistance 124. In particular, in the example considered the measurement resistance 122 is implemented through a series connection of the first measurement resistance 122a and of the second measurement resistance 122b, and likewise the replica resistance 124 is implemented through a series connection of the first replica resistance 124a and of the second replica resistance 124b. It is submitted that the measurement resistance 122 can be accounted as being composed by the series connection of the first measurement resistance 122a and of the second measurement resistance 122b by assuming that the differential amplifier 121 has an ideal input stage i.e., has a infinite input resistance, causing a virtual short circuit between the positive input terminal and the negative input terminal, hence there is no voltage difference between the positive input terminal and the negative input terminal, and no current is allowed into or out the differential amplifier 121 through the positive input terminal and the negative input terminal.

In other embodiments, the external replica resistance 128 can have a resistance value which is substantially different with respect to the measurement resistance 122 and the replica resistance 124. For example, the external replica resistance 128 can be chosen with a value of two times the measurement resistance 122.

The generated reference current IR flows through the replica resistance 124 i.e., the series connection of the first replica resistance 124a and the second replica resistance 124b, thus building up a voltage across the replica resistance 124.

Such voltage is measured through the ADC 112, which can be selectively coupled to the terminals of the replica resistance 124 through a second pair of switches S2, which are opened or closed under the control of the control unit 114. Thus, by acting on the first couple of switches S1 and on the second couple of switches S2, the ADC 112 can measure either the voltage VS outputted by the transimpedance amplifier 120, or the voltage across the measurement resistance 124.

In various embodiments, the reference voltage VR, which is employed by the reference current generator 116, is also employed as a reference voltage in the ADC 112, thus enhancing the immunity of the current sensing circuit 100 to possible drift of the reference voltage VR.

Summarizing, in the embodiment considered the reference current generator 116 fixes the reference current IR, which is generated from the reference voltage VR and the external reference resistor 128 having high long-term stability, and being connected to the reference current generator 116 by a dedicated pad RR. The reference current IR flows through the first replica resistance 124a and the second replica resistance 124b i.e., the resistances aimed at tracking the resistance drift occurring in the measurement resistances 122a and 122b. The reference voltage VR is the same used as reference voltage for the ADC circuit 112, thus facilitating the cancellation of possible drift of the reference voltage.

Subsequently, the ADC circuit 112 is used to track the drift DR of the resistors by measuring the voltage D4 across the replica resistances 124a and 124b. To this end, the control unit 114 commands the opening of the first pair of switches S1, and the closing of the second pair of switches S2.

Accordingly, the control unit 114 acquires the voltage D4 across the replica resistance 124 through the ADC circuit 112, which is then stored in the non-volatile memory 146 of the control unit 114 for performing further computations.

In particular, the voltage D4 across the replica resistance 124 is acquired for determining either a calibration baseline value VB, or a calibration value VC, according to the time at which the measurement is performed. As it will be made clearer in the following, in a first time instant T0 e.g., when the current sensing circuit 100 is manufactured, the measurement of the voltage D4 across the replica resistance 124 is employed for determining the calibration baseline value VB, whereas in further time instants TN e.g., when the current sensing circuit 100 is employed by a user, such voltage measurement is employed for determining a calibration value VC, which is then exploited for calibrating the current measurement, and returning a calibrated current measurement CS.

In this regard, the compensation for drift of measurement resistances 122a, 122b in the current sensing circuit 100 is based on the evaluation of a calibration parameter CP, which is subsequently applied by the control unit 114 to the raw digital value DS, outputted by the ADC circuit 112, as to obtain the calibrated current measurement CS. To this end, in solutions as proposed herein the two replica resistors 124a and 124b are respectively replicas of the first measurement resistance 122a and of the second measurement resistance 122b i.e., they are realized using the same process and with the same specifications.

In order to provide sufficient matching of the replica resistors with the measurement resistors, thus enabling effective replication of the drifts of the measurement resistors 122a, 122b on the replicas 124a, 124b, a suitable layout is adopted.

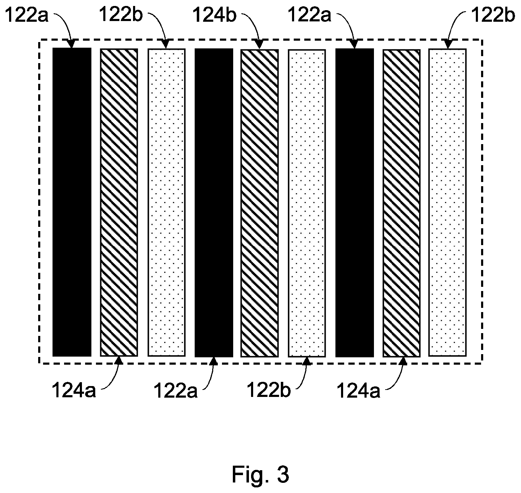

In this regard, Figure 3 is illustrative of a possible example of resistors layout in an integrated circuit, where the measurement resistance 122a, 122b and the replica resistances 124a, 124b are interdigitated. In such example, the resistor bank is designed by interlacing the two differential feedback resistors 122a, 122b with the tracking replica resistors 124a, 124b.

In particular, the cancellation of the resistance drift DR is performed in accordance to the following.

As mentioned before, the reference current IR, which is generated by the reference current generator 116, is let flow through the replica resistances 124a, 124b, then the voltage drop D4 across such resistances is measured through the ADC circuit 112. In particular, the reference current IR as provided by the reference current generator 116 has a value IR = VR / R128, hence at a first time instant, namely a first time instant T0, the voltage measured across the replica resistances 124a and 124b by the ADC circuit 112, indicated as V124, is: ${V}_{124} = {V}_{R} \frac{{R}_{124}}{{R}_{128}}$

Where the term R124 is the overall resistance resulting from the series connection of the first replica resistance 124a and of the second replica resistance 124b, and where the term R128 indicates the resistance of the external reference resistor 128. Such voltage is subsequently acquired by the ADC circuit 112, that returns a corresponding digital representation. The output code of the ADC circuit 112 is then stored as the calibration baseline value VB in the non-volatile memory 146 of the control unit 114.

Accordingly, the calibration baseline VB i.e., the digital output code outputted by the ADC circuit 112 at the first time instant T0, is: $VB = \frac{{V}_{124}}{\frac{{V}_{R}}{{2}^{N}}} = \frac{{V}_{R} \frac{{R}_{124}}{{R}_{128}}}{\frac{{V}_{R}}{{2}^{N}}} = {2}^{N} ⋅ \frac{{R}_{124}}{{R}_{128}}$

Where the parameter N is indicative of the number of bits of resolution of the ADC circuit 112. The calibration baseline parameter VB, stored in the non-volatile memory 146, is then employed in the subsequent calibration steps for determining a calibration parameter CP for the correction of the current measurement.

As mentioned, this first calibration step is performed at the first time instant T0, which is regarded as the time instant in which the external reference resistance 128 is soldered in the current measurement circuit 100 e.g., at time of manufacturing.

Subsequently, next calibration measurements are performed periodically for acquiring calibration values VC, usable for determining the amount of resistance drift DR. For instance, a further calibration is performed at a further time instant TN, finding a resistance variation DR on the replica resistances 124a, 124b. In such case, the voltage measured by the ADC circuit 112 is: ${V}_{124} = {V}_{R} \frac{{R}_{124} + DR}{{R}_{128}}$

Hence, the corresponding calibration value VC i.e., the digital code outputted by the ADC circuit 112 is: $VC = \frac{{V}_{S}}{\frac{{V}_{R}}{{2}^{N}}} = \frac{{V}_{R} \frac{{R}_{124} + DR}{{R}_{128}}}{\frac{{V}_{R}}{{2}^{N}}} = {2}^{N} ⋅ \frac{{R}_{124} + DR}{{R}_{128}}$

By combining the above equations, the value of the calibration parameter CP is obtained: $CP = \frac{VB}{VC} = \frac{{R}_{124}}{{R}_{124} + DR}$

As described previously, the transimpedance amplifier 120 and the ADC circuit 112 are employed for measuring the input current IS, by closing the first couple of switches S1 and opening the second pair of switches S2, thus connecting the output of the current sensing circuit 100 to the input port of the ADC circuit 112. At the initial time instant T0, the voltage output VS of the transimpedance amplifier 120 and the corresponding digital output code DS outputted by the ADC circuit 112 are, respectively: ${VS}_{T 0} = IS ⋅ {R}_{122} {DS}_{T 0} = \frac{{VS}_{T 0}}{\frac{{V}_{R}}{{2}^{N}}} = {2}^{N} \frac{IS ⋅ {R}_{122}}{{V}_{R}}$

On the other hand, at the further time instant TN, the output of the transimpedance amplifier 120 and of the ADC circuit 112 are: ${VS}_{TN} = IS ⋅ \left({R}_{122}+DR\right) {DS}_{TN} = \frac{{VS}_{TN}}{\frac{{V}_{R}}{{2}^{N}}} = {2}^{N} \frac{IS ⋅ \left({R}_{122}+DR\right)}{{V}_{R}}$

Therefore, the calibration parameter CP can be employed for nullifying the effect of resistance variation DR, thus yielding the calibrated current measurement CS: $CS = DS ⋅ CP = {2}^{N} \frac{IS ⋅ \left({R}_{122}+DR\right)}{{V}_{R}} ⋅ \frac{{R}_{124}}{{R}_{124} + DR}$

In the hypothesis that the two replica resistances 124a and 124b are perfectly matched to the measurement resistances 122a and 122b, hence that the measurement resistance 122 is equal to the replica resistance 124, the above expression can be further simplified: $CS = {2}^{N} \frac{IS ⋅ \left({R}_{122}+DR\right)}{{V}_{R}} ⋅ \frac{{R}_{124}}{{R}_{124} + DR} = {2}^{N} \frac{IS ⋅ {R}_{124}}{{V}_{R}}$

From the above expression, it can be appreciated that the calibration parameter CP is equal to 1 in the case the second measurement of the resistances is performed at the same initial time instant T0, thus assuming that the resistance drift DR is null at the initial instant T0.

The working principle of the embodiment described with reference made to Figure 2 can be summarized by a method 200 for performing calibration of the current sensing circuit 100.

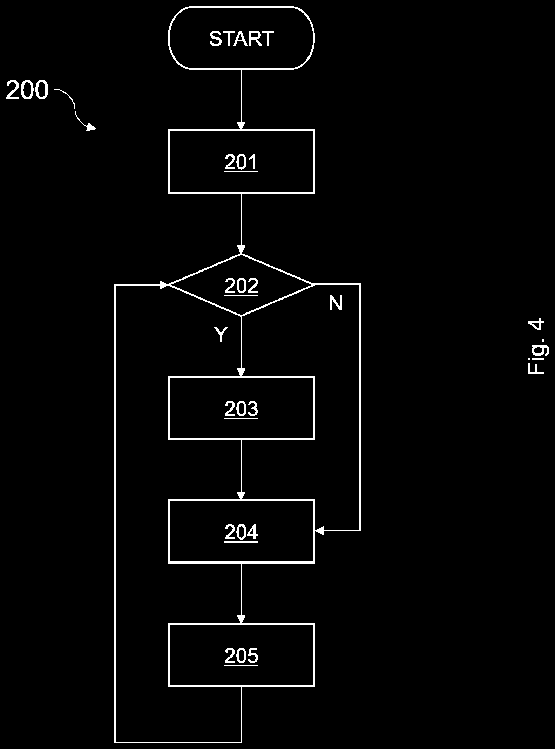

In this regard, Figure 4 is illustrative of a flowchart representing the method 200 for performing calibration of the current sensing circuit 100 according to solutions as described herein.

After a starting step, in a first phase 201 the control unit 114 performs a first reference calibration measurement, then stores the result as a calibration baseline VB in the non-volatile memory 146 comprised therein. Such first step 201 may be performed at the first time instant T0 e.g., when the device is manufactured.

In particular, during the first phase 201 of performing the first calibration measurement, the control unit 114 commands the opening of the first pair of switches S1, and the closing of the second pair of switches S2. This way, the output terminals of the transimpedance amplifier 120 are decoupled from the input terminals of the ADC circuit 112, which are employed for measuring the voltage across the replica resistances 124a, 124b coupled thereto.

After configuring the first pair of switches S1 and the second pair of switches S2, the control unit 114 instructs the reference current generator circuit 116 to provide the reference current IR, which is let flow through the first replica resistance 124a and the second replica resistance 124b.

While the reference current IR is flowing through the first replica resistance 124a and the second replica resistance 124b, the ADC circuit 112 converts the voltage across the series connection of the first replica resistance 124a and the second replica resistance 124b i.e., the replica resistance 124.

The determined digital value is then stored as calibration baseline value VB in the nonvolatile memory 146 of the control unit 114, and is employed in the subsequent phases for performing the calibration of the current sensing circuit 100.

Consequently, the control unit 114 begins the measuring of the input current IS. To this end, the control unit 114 commands the closing of the first pair of switches S1, and the opening of the second pair of switches S2. This way, the output terminals of the transimpedance amplifier 120 are now coupled to respective input terminals of the ADC circuit 112, whereas the terminals of the replica resistances 124a, 124b are decoupled from the ADC circuit 112.

The transimpedance amplifier 120 provides at its output terminals the output voltage VS indicative of the intensity of the input current IS. The output voltage VS is then acquired through the ADC circuit 112, which produces as output the digital code DS representing the output voltage VS. The value found for the digital code DS is then stored in a memory of the control unit 114 such as, for instance, the non-volatile memory 146.

As mentioned, the first calibration step 201 may be performed when the current sensing circuit 100 is being manufactured, as initial calibration step. Thus, after the first calibration step 201 is performed, the obtained value of the calibration baseline VB is stored in the non-volatile memory 146 of the control unit 114, and is employed by the current sensing circuit 100 for applying the correction on the subsequent current measurements.

Further, in various embodiments the calibration baseline value VB is associated to a timestamp value TZ, which indicates the time at which the calibration baseline VB is acquired. Likewise, the timestamp value TZ associated to the calibration baseline value VB is stored in the non-volatile memory 146 of the control unit 114.

In a next step 202, the control unit 114 verifies whether a new calibration is required. For instance, the step 202 of checking whether a new calibration is required, and the subsequent steps of the method 200 that are described in the following, may be performed at a generic further time instant TN, which is anyway subsequent to the first time instant T0, at which the first calibration step 201 is performed.

In particular, the determination of whether a new calibration step is necessary may be performed on the basis of the time elapsed from the occurrence of the last calibration.

In various embodiments each calibration parameter, such as the calibration baseline value VB, the calibration value VC, and the calibration parameter CP, determined at a respective calibration step is associated to the timestamp value TZ indicative of when the calibration step is performed. To this end, the current sensing circuit 100 comprises circuitry configured to keep track of time, such as a real-time clock circuit, a timer, or a free-running counter.

Thus, the step 202 of checking whether a new calibration is required can be carried out by the control unit 114 by comparing the current time with the timestamp TZ associated to the last calibration performed. If the time difference between the two is greater than, or equal to, a predetermined threshold value, then the control unit 114 determines that a new calibration is required.

In the positive, in a phase 203 performs a calibration measurement, and subsequently determines a new value for the calibration parameter CP.

In this regard, during the calibration phase 203 the control unit 114 commands the opening of the first pair of switches S1, and the closing of the second pair of switches S2, in such a way that the input terminals of the ADC circuit 112 are employed for measuring the voltage V124 across the replica resistances 124a, 124b coupled thereto.

Consequently, the control unit 114 instructs the reference current generator circuit 116 to provide the reference current IR, which flows through the first replica resistance 124a and the second replica resistance 124b.

While the reference current IR is flowing through the first replica resistance 124a and the second replica resistance 124b, the ADC circuit 112 measures the voltage V124 across the series connection of the first replica resistance 124a and the second replica resistance 124b i.e., the replica resistance 124. As mentioned in the foregoing, the voltage across the replica resistance 124 measured at the further time instant TN comprises contributions from the replica resistance 124 and from the corresponding resistance drift DR. Hence, the measured voltage is V124 = R124 * IR.

The determined calibration voltage V124 is then acquired by the ADC circuit 112, which returns the corresponding digital code i.e., the calibration value VC.

The control unit 114 subsequently receives the calibration value VC, then determines the calibration parameter CP on the basis of the calibration baseline value VB and of the received calibration value VC, then stores the determined calibration parameter CP in the nonvolatile memory 146 of the control unit 114 for use in the subsequent phases for performing the calibration of the current sensing circuit 100. In particular, the calibration parameter CP is determined as a ratio of the calibration baseline VB and of the calibration measurement VC i.e., CP = VB / VC.

Successively, the method 200 continues in a phase 204. In particular, the phase 204 may be executed after the determination of a new calibration parameter CP i.e., after the execution of the phase 203 described above, or after the control unit 114 determines, in the phase 202, that a new calibration is not required.

In the phase 204 the current sensing circuit 100 performs a new current measurement. To this end, the control unit 114 commands the closing of the first pair of switches S1, and the opening of the second pair of switches S2, in such a way that the input terminals of the ADC circuit 112 are employed for measuring the voltage VS outputted by the transimpedance amplifier 120 coupled thereto. Consequently, the ADC circuit 112 acquires the voltage VS outputted by the transimpedance amplifier 120, and outputs a corresponding digital code DS. In turn, the digital code DS, indicative of the uncalibrated current measurement, is received as input by the control unit 114.

Successively, in a phase 205 the control unit 114 applies the correction to the digital code DS received by the ADC circuit 112. In particular, the correction is applied on the basis of the calibration parameter CP, which is stored in the non-volatile memory 146, and is accessed for correcting the current measurement in accordance with what discussed in the foregoing. Thus, the control unit 114 produces as output the calibrated current measurement CS, obtained as CS = DS * CP, where DS is the uncalibrated current measurement outputted by the ADC circuit 112, and CP is the calibration parameter stored in the non-volatile memory 146.

After the execution of the step 205 is completed, the method 200 can be reiterated starting from the phase 202, thus assuring a continuous checking of whether a new calibration is required or not during the functioning of the current sensing circuit 100.

Therefore, the calibration parameter CP of the current sensing circuit 100 is stored in the non-volatile memory 146 and can assume different values according to the conditions in which the current sensing circuit 100 is employed. Specifically, if the current sensing circuit 100 has undergone only the first calibration, performed at the first time instant T0, the calibration parameter CP takes a value equal to 1, whereas if further calibration steps are performed, in accordance with the phase 203 described above, the calibration parameter CP takes the value of the ratio between the calibration baseline VB and the calibration voltage VC determined in the latest calibration, which is performed at the generic further time instant TN.

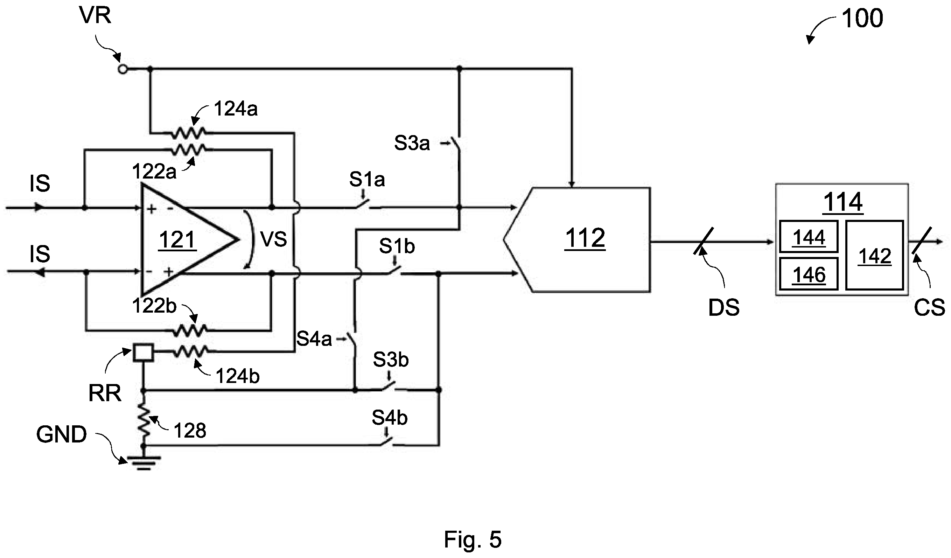

Figure 5 is illustrative of a detailed schematic diagram of a second embodiment of current sensing circuit 100 according to solutions as proposed herein.

In the embodiment considered, the first measurement resistance 122a is coupled between the positive input terminal and the negative output terminal of the differential amplifier 121. Likewise, the second measurement resistance 122b is coupled between the negative input terminal and the positive output terminal of the differential amplifier 121. As illustrated, the differential amplifier 121 receives at its positive input terminal the input current IS, which is circulated in the feedback branches comprising the first measurement resistance 122a, whereas the negative input terminal of the differential amplifier 121, thus of the transimpedance amplifier 120, outputs the same input current IS after circulating it through the second measurement resistance 122b.

The differential amplifier 121 produces at its output terminals the voltage VS representing the input current IS, the output voltage VS being obtained as a voltage difference between voltages at the positive output terminal and at the negative output terminal.

As in the embodiment discussed previously, the replica resistance 124 can be split in a first replica resistance 124a and in a second replica resistance 124b. Specifically, the series connection of the first replica resistance 124a and of the second replica resistance 124b constitutes the replica resistance 124, which has a resistance value R124 equal to the sum of the first replica resistance 124a and of the second replica resistance 124b.

The reference voltage VR is provided at the corresponding reference voltage pad VR, which is also coupled to the first replica resistance 124a. The second replica resistance 124b has a first terminal coupled to the first replica resistance 124a, and a second terminal coupled to the external resistance pad RR.

In various embodiments, the current sensing circuit 100 is configured to couple to the external reference resistance 128, which may be a discrete component, hence not integrated in an integrated circuit, and has long-term stability. In the example illustrated in Figure 5, the external reference resistance 128 is coupled between the external resistance terminal RR, and the ground reference GND.

The Analog-to-Digital converter 112 has a first input terminal and a second input terminal for receiving the input signal to convert i.e., the voltage VS outputted by the transimpedance amplifier 120. In various embodiments, the input terminals of the ADC circuit 112 are selectively couplable to different input sources e.g., to the transimpedance amplifier 120, to the voltage reference VR, and the ground reference GND, by means of switches provided in the current sensing circuit 100.

In particular, the first input terminal of the ADC circuit 112 is selectively couplable to the negative output terminal of the transimpedance amplifier 120, whereas the second input terminal of the ADC circuit 112 is selectively couplable to the positive output terminal of the transimpedance amplifier 120. The negative output terminal and the positive output terminal of the transimpedance amplifier 120 are respectively couplable to the first and second input terminals of the ADC circuit 112 by means of the first pair of switches S1, as in the embodiment discussed previously with reference to Figure 2.

Similar to the embodiment shown in Figure 2, the first couple of switches S1 comprises a first switch S1a and a second switch S1b and allows to couple the input terminals of the ADC 112 to the output terminals of the transimpedance amplifier 120. As illustrated in Figure 5, the first switch S1a of the first couple of switches S1 couples the negative output terminal of the transimpedance amplifier 120 to the ADC circuit 112, whereas the second switch S1b of the first couple of switches S1 couples the positive output terminal of the transimpedance amplifier 120 to the ADC circuit 112.

This way, when the switches of the first couple of switches S1 are closed, the negative output terminal of the differential transimpedance amplifier 120 is in contact with the first input terminal of the ADC 112, and the positive output terminal of the differential transimpedance amplifier 120 is in contact with the second input terminal of the ADC 112.

Further, the current sensing circuit 100 includes a third pair of switches S3 comprising a first switch S3a and a second switch S3b, and a fourth pair of switches comprising a first switch S4a and a second switch S4b.

The first switch S3a of the third pair of switches S3 has a first terminal coupled to the voltage reference pad VR, and a second terminal coupled to the first input terminal of the ADC circuit 112. The second switch S3b of the third pair of switches S3 has a first terminal coupled to the external resistance pad RR, and a second terminal coupled to the second input terminal of the ADC circuit 112.

In other words, when the third pair of switches S3 is closed and the remaining pairs of switches are opened i.e., the first pair of switches S1 and the fourth pair of switches S4, the input terminals of the ADC 112 are coupled to the terminals of the replica resistance 124 i.e., the terminal of the first replica resistance 124a coupled to the voltage reference pad VR and the terminal of the second replica resistance 124b coupled to the external resistance pad RR.

The first switch S4a of the fourth pair of switches S4 has a first terminal coupled to the first input terminal of the ADC circuit 112, and a second terminal coupled to the external resistance pad RR, whereas the second switch S4b of the fourth pair of switches S4 has a first terminal coupled to the second input terminal of the ADC circuit 112, and a second terminal coupled to the ground reference GND.

This way, when the switches S4a and S4b of the fourth pair of switches S4 are closed, and the remaining pairs of switches are opened i.e., the first pair of switches S1 and the third pair of switches S3, the first input terminal of the ADC circuit 112 is coupled to the external reference resistance contact RR, to which a terminal of the external reference resistance 128 is coupled, whereas the second input terminal of the ADC circuit 112 is coupled to the ground reference GND, to which the other terminal of the external reference resistance 128 is coupled, thereby allowing the voltage measurement across the external reference resistance 128.

Similar to the previously discussed embodiments, the ADC circuit 112 outputs a digital code DS corresponding to the voltage measured at its input terminals. The digital output code DS is then received by the control unit 114, which applies one or more corrections for outputting a calibrated digital output code CS.

In particular, according to the solutions here described, the calibration of the current measurement is performed on the basis of two different quantities, which are to be measured on the resistive ladder formed by the first replica resistance 124a, the second replica resistance 124b, and the external reference resistance 128.

As anticipated, the measurement of such voltage drop can be performed in steps. In a first step, the control unit 114 commands the closing of the third couple of switches S3, whereas the remaining switches i.e., the first couple of switches S1 and the fourth couple of switches S4 are kept open. When the third couple of switches S3 is closed, the control unit 114 acquires the voltage drop across the first replica resistance 124a and the second replica resistance 124b by reading the corresponding digital value outputted by the ADC 112, which has its first input terminal coupled to the reference voltage terminal VR, and its second input terminal coupled to the external reference resistance contact RR.

Subsequently, the control unit 114 commands the opening of the third couple of switches S3, and the closing of the fourth couple of switches S4, as to couple the input terminals of the ADC 112 to the terminals of the external reference resistance 128, thus enabling the measurement of the voltage drop across the external reference resistance 128. As the fourth couple of switches S4 is closed, the control unit 114 acquires the voltage drop across the external reference resistance 128 by reading the corresponding digital output code DS outputted by the ADC 112.

The afore-mentioned voltage measurements are to be performed multiple times, wherein the first time each measurement is performed is at the first time instant T0 e.g., at production time or, in general, when it can be assumed that the components provided in the current sensing circuit 100 have no aging.

For the sake of computation of the correction to be applied to the current measurement, the calibration strategy proposed in this embodiment requires the measurement of two different quantities on the resistive ladder i.e., the voltage drop across the replica resistance 124, and the voltage drop across the external reference resistance 128.

Such measurements can be performed in two times, by closing the fourth pair of switches S4, while the remaining switches are opened, for acquiring the voltage drop across the external reference resistance 128, and by closing the third pair of switches S3, while the remaining switches are open, for acquiring the voltage across the replica resistance 124.

Accordingly, when the third pair of switches S3 is closed, the voltage drop V124 across the replica resistance 124 read by the ADC circuit 112 is: ${V}_{124 , T 0} = {V}_{R} \frac{{R}_{124}}{{R}_{124} + {R}_{128}}$

Accordingly, the ADC circuit 112 acquires such voltage drop and converts it into a corresponding output code D4: $D {4}_{T 0} = {2}^{N} ⋅ \frac{{V}_{124 , T 0}}{{V}_{R}} = {V}_{R} \frac{{2}^{N}}{{V}_{R}} ⋅ \frac{{R}_{124}}{{R}_{124} + {R}_{128}} = {2}^{N} \frac{{R}_{124}}{{R}_{124} + {R}_{128}}$

On the other hand, when the fourth pair of switches S4 is closed, the voltage drop V128 across the reference resistance 128 read by the ADC circuit 112 is: ${V}_{128 , T 0} = {V}_{R} \frac{{R}_{128}}{{R}_{124} + {R}_{128}}$

Accordingly, the ADC circuit 112 acquires the voltage drop and converts it into a corresponding output code D8: $D {8}_{T 0} = {2}^{N} ⋅ \frac{{V}_{128 , T 0}}{{V}_{R}} = {V}_{R} \frac{{2}^{N}}{{V}_{R}} ⋅ \frac{{R}_{128}}{{R}_{124} + {R}_{128}} = {2}^{N} \frac{{R}_{128}}{{R}_{124} + {R}_{128}}$

Consequently, the control unit 114 combines the measurements obtained from the two aforementioned configurations for obtaining the value of calibration baseline parameter VB, which is stored in the non-volatile memory 146. Specifically, the calibration baseline parameter VB is determined as: $VB = \frac{D {4}_{T 0}}{D {8}_{T 0}} = \frac{{2}^{N} \frac{{R}_{124}}{{R}_{124} + {R}_{128}}}{{2}^{N} \frac{{R}_{128}}{{R}_{124} + {R}_{128}}} = \frac{{R}_{124}}{{R}_{128}}$

Subsequent calibration steps, which are performed in general at the further time instant TN i.e., after manufacturing of the circuit, allow the current sensing circuit 100 to catch the drift of the measurement resistance 122, composed by the series connection of the first measurement resistance 122a and of the second measurement resistance 122b. In fact, at the further time instant TN, the measurement resistance 122 is affected by drift, which causes a resistance variation DR on the measurement resistance 122. Accordingly, the same resistance variation DR is found at the replica resistance 124.

As discussed previously, the measurement resistance 122 and the replica resistance 124 are implemented by means of interdigitated resistors in an integrated circuit, thus are closely packed, allowing the tracking of the resistance drift of the measurement resistance 122 by the replica resistance 124.

Thus, in order to determine the value for correcting the current measurements, the current sensing circuit 100 acquires again the voltage values across the replica resistance 124 and the external resistance 128, in accordance with the steps performed in the first calibration phase at the first time instant T0.

To this end, the control unit 114 commands the closing of the third pair of switches S3, and the opening of the remaining switches, for coupling the input terminals of the ADC circuit 112 to the terminals of the replica resistance 124, which forms a resistor ladder along with the external reference resistance 128. In particular, the voltage V124 across the replica resistance 124, accounting the resistance drift DR is: ${V}_{124 , TN} = {V}_{R} \frac{{R}_{124} + DR}{{R}_{124} + DR + {R}_{128}}$

Accordingly, the corresponding digital value D4 outputted by the ADC circuit 112 is: $D {4}_{TN} = {2}^{N} ⋅ \frac{{V}_{124 , TN}}{{V}_{R}} = \frac{{2}^{N}}{{V}_{R}} ⋅ {V}_{R} \frac{{R}_{124} + DR}{{R}_{124} + DR + {R}_{128}} = {2}^{N} \frac{{R}_{124} + DR}{{R}_{124} + DR + {R}_{128}}$

After measuring the voltage across the replica resistance 124, the control unit 114 configures the current sensing circuit 100 for measuring the voltage across the external reference resistance 128. To this end, the control unit 114 commands the closing of the fourth pair of switches S4, and the opening of the remaining switches. The voltage V128 across the external reference resistance 128 is: ${V}_{128 , TN} = {V}_{R} \frac{{R}_{128}}{{R}_{124} + DR + {R}_{128}}$

The corresponding digital code D8 outputted by the ADC circuit 112 is: $D {8}_{TN} = {2}^{N} ⋅ \frac{{V}_{128 , TN}}{{V}_{R}} = \frac{{2}^{N}}{{V}_{R}} {V}_{R} ⋅ \frac{{R}_{128}}{{R}_{124} + DR + {R}_{128}} = {2}^{N} \frac{{R}_{128}}{{R}_{124} + DR + {R}_{128}}$

By combining the digital codes D4 and D8, corresponding to the two voltage measurements V124 and V128, the control unit 114 determines a value of their ratio, thus obtaining a calibration value VC: $VC = \frac{D {4}_{TN}}{D {8}_{TN}} = {2}^{N} \frac{{R}_{124} + DR}{{R}_{124} + DR + {R}_{128}} ⋅ \frac{{R}_{124} + DR + {R}_{128}}{{2}^{N} ⋅ {R}_{128}} = \frac{{R}_{124} + DR}{{R}_{128}}$

After computation, the calibration value VC is stored in the system memory 144 of the control unit 114 for further computations. Consequently, the control unit 114 determines the calibration parameter CP on the basis of the calibration baseline VB and of the calibration value VC: $CP = \frac{VB}{VC} = \frac{{R}_{124}}{{R}_{124} + DR}$

The calibration parameter CP is then stored in the non-volatile memory 146 of the control unit 114, as it will be used for correcting the current measurements performed by the current sensing circuit 100.

For example, when the current sensing circuit 100 performs a current measurement of the input current IS, the voltage VS at the output of the transimpedance amplifier 120 i.e., the voltage between the positive output terminal and the negative output terminal of the transimpedance amplifier 120, is VS = IS · (R₁₂₂ₐ + R_{122b}). Accordingly, the ADC circuit 112 outputs a corresponding output code DS: $DS = \frac{{2}^{N}}{{V}_{R}} ⋅ VS = {2}^{N} ⋅ \frac{IS ⋅ \left({R}_{122 a}+{R}_{122 b}\right)}{{V}_{R}}$

However, when taking into account the resistance drift DR, the voltage VS outputted by the transimpedance amplifier 120 and the corresponding digital code DS outputted by the ADC circuit 112 are indicated as: $VS = IS ⋅ \left(\begin{matrix}{R}_{122 a} + {R}_{122 b} \\ + DR\end{matrix}\right) DS = \frac{{2}^{N}}{{V}_{R}} ⋅ VS = {2}^{N} ⋅ \frac{IS ⋅ \left({R}_{122 a}+{R}_{122 b}+DR\right)}{{V}_{R}}$

Accordingly, the control unit 114 applies the correction parameter CP for nullifying the effect of the resistance drift DR on the measured value of the input current IS. In particular, the control unit 114 may apply to the uncalibrated measurement the correction parameter CP by performing a product between the two quantities: CS = DS · CP.

By further assuming that the measurement resistances 122a and 122b are respectively equal to the replica resistances 124a and 124b, hence that the measurement resistance 122 is equal to the replica resistance 124, the calibrated current measurement CS reads: $CS = {2}^{N} \frac{IS \left({R}_{122}+DR\right)}{{V}_{R}} ⋅ \frac{{R}_{122}}{{R}_{122} + DR} = {2}^{N} \frac{IS ⋅ {R}_{122}}{{V}_{R}}$

In view of the above, it is clear that the solution as proposed herein advantageously allows to nullify the contributions due to resistance drift DR in the current measurements performed by means of the current sensing circuit 100 according to solutions as proposed herein.

As done in the foregoing with the first embodiment of current sensing circuit 100 discussed, the working principle of the embodiment described with reference made to Figure 5 can be summarized by a method 250 for performing calibration of the current sensing circuit 100.

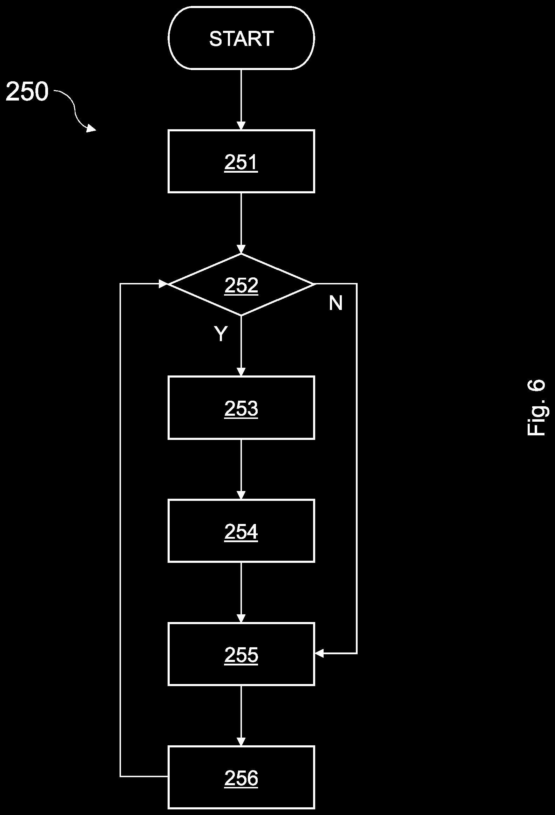

In this regard, Figure 6 is illustrative of a flowchart representing the method 250 for performing calibration of the current sensing circuit 100 according to solutions as described herein.

After a starting step, in a first phase 251 the control unit 114 performs a first reference calibration measurement, then stores the result as a calibration baseline VB the non-volatile memory 146. Such first step 251 may be performed at the first time instant T0 e.g., when the device is manufactured.

In particular, during the first phase 251 of performing the first calibration measurement, the control unit 114 commands the opening of the first pair of switches S1 and of the fourth pair of switches S4, and the closing of the third pair of switches S3. This way, the output terminals of the transimpedance amplifier 120 are decoupled from the input terminals of the ADC circuit 112, which are employed for measuring the voltage across the replica resistances 124a, 124b coupled thereto.

After configuring the first pair of switches S1, the third pair of switches S3, and the fourth pair of switches S4, the control unit 114 acquires from the ADC circuit 112 the digital code corresponding to the measured voltage across the replica resistance 124, and stores such result in the system memory 144.

Consequently, the control unit 114 commands the closing of the fourth pair of switches S4, and the opening of the first pair of switches S1 and of the third pair of switches S3, in order to allows the measurement of the voltage across the external reference resistance 128. After configuring the switches, the control unit 114 acquires from the ADC circuit 112 the digital code corresponding of the measured voltage across the external reference resistance 128, and stores in the system memory 144 for further computations.

When the voltage across the replica resistance 124 and the voltage across the external reference resistance 128 are available, the control unit 114 computes the calibration baseline parameter VB on the basis of such voltages, and stores the found value of calibration baseline VB in the non-volatile memory 146.

Successively, in a second phase 252 the control unit verifies whether a new calibration is required or not. As discussed previously, the step 252 of checking whether a new calibration is required, and the subsequent steps of the method 250 that are described in the following, may be performed at a generic time instant TN, which is anyway subsequent to the first time instant T0, at which the first calibration step 251 is performed.

The determination of whether a new calibration step is necessary may be performed on the basis of the time elapsed from the occurrence of the last calibration. To this end, the control unit 114 compares a timestamp associated to the calibration parameter CP stored in the non-volatile memory 146 with the current time. In response to detecting that the difference between the current time and the timestamp of the latest calibration parameter CP exceeds a predetermined threshold value, the control unit 114 determines that a new calibration is required. On the contrary, if the time elapsed from the latest calibration does not exceed the predetermined threshold value, there is no need of a new calibration.

In response to detecting that a new calibration is required, the control unit 114 performs, in a further phase 253, a new calibration of the current sensing circuit 100 by measuring the voltage across the replica resistance 124, measuring the voltage across the external reference resistance 128, and based on these values, computing a calibration value VC. On the basis of the calibration baseline VB and of the calibration value VC, the control unit 114 determines the new calibration parameter CP in accordance with the above description, and stores the found calibration parameter CP in the non-volatile memory 146 in a successive phase 254.

On the contrary, if a new calibration is not required, in a successive phase 255 the control unit 114 configures the current sensing circuit 100 to perform a measurement of the input current IS, and to consequently apply the correction on the basis of the calibration parameter CP in a phase 256.

As anticipated, the first calibration step 251 may be performed when the current sensing circuit 100 is being manufactured, as initial calibration step. Thus, after the first calibration step 251 is performed, the obtained value of the calibration parameter CP is stored in the non-volatile memory 146 of the control unit 114, and will be employed by the current sensing circuit 100 for applying the correction on the subsequent current measurements.

On the other hand, the further steps i.e., the steps 252-256, are performed at a generic further time instant TN, after the manufacturing of the current sensing circuit 100.

It is also noted that, in order to provide continuous operation, the method 250 can be re-iterated indefinitely, until the current sensing circuit 100 is powered on.

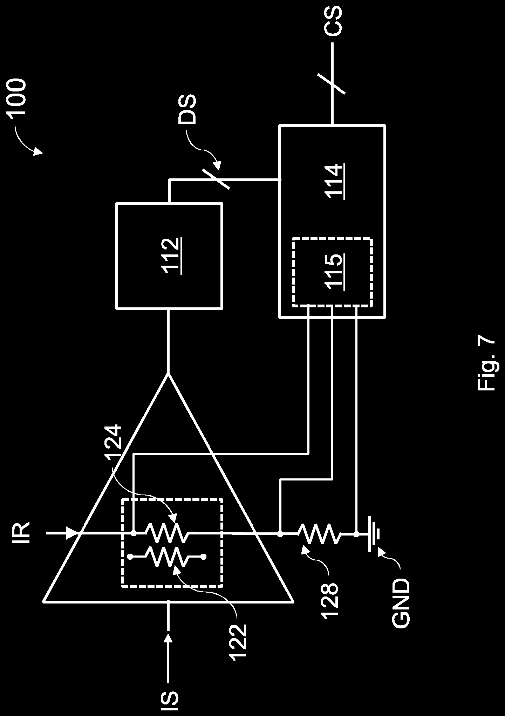

Figure 7 is illustrative of a schematic diagram of a further embodiment of current sensing circuit 100 according to solutions as proposed herein.

As illustrated, in the embodiment considered the control unit 114 of the current sensing circuit 100 further comprises a second Analog-to-Digital converter 115, which is provided in addition to the first ADC circuit 112. This way, the ADC circuit 112 can be employed for performing the measurement of the input current IS, while the correction parameter CP is directly computed by means of the control unit 114, using the second ADC circuit 115 provided therein.

It is observed that the solution as presented herein may provide less accuracy with respect to the solutions described with reference made to Figure 2 and Figure 5. However, the same arrangement may be advantageous in that the measurements aimed at the evaluation or update of the calibration parameter CP can be performed in parallel i.e., at the same time, to the current measurements without need to interrupt the measurement of the current.

Further, it is worth noting that from an implementation point of view, the computation of the calibration parameter CP and application of such calibration parameter CP to the uncalibrated measurement DS may be performed by two separated different units.

As an example, the control unit 114 may be employed for the evaluation of the calibration parameter CP, whereas a dedicated digital correction unit i.e., a dedicated digital circuit, may be employed for performing the correction on the uncalibrated measurement DS. In this regard, the control unit 114 may be implemented with a DSP, Digital Signal Processor, a microcontroller, or a microprocessor, and the dedicated digital circuit may likewise be implemented with a DSP, a microcontroller, a microprocessor, or an ASIC.

In view of the above, the features of the solution as described herein are clear, as well as its advantages. Specifically, the solution described herein provide a new mixed-signal drift cancellation method and system, for providing continuous and accurate calibration in current sensing circuits by exploiting matched replica resistances and mixed analog and digital structures.

Solutions as proposed herein thus respond to the pressing need for current sensor gain adaptation, providing high accuracy while allowing for area saving solutions.

Further, adaptations of the solutions described herein can be employed for measuring other physical quantities, such as temperature, charge, etc. In other embodiments, the resistors used as gain defining elements may be substituted by capacitors e.g., switched capacitors acting as resistances under specific clock conditions.

Of course, without prejudice to the principle of the invention, the details of construction and the embodiments may vary widely with respect to what has been described and illustrated herein purely by way of example, without thereby departing from the scope of the present invention, as defined by the ensuing claims.

## Claims

1. A current sensing circuit (100) for measuring an input current (IS) by providing a digital representation (CS) thereof, the current sensing circuit (100) comprising:
- a transimpedance amplifier (120) comprising a measurement resistance (122) the value of which is subject to a change in time (DR), and configured to receive as input the input current (IS) and to provide at respective output terminals a voltage (VS) proportional to the input current (IS);
- a replica resistance (124) having a resistance value substantially equal to the initial (T0) value of the measurement resistance (122), and subject to the same change in time (DR) of the measurement resistance (122);
- a reference resistance (128) having a resistance value with long-term stability;
- a reference voltage pad (VR) for receiving a reference voltage (VR);
- a first analog-to-digital converter (112) coupled to the transimpedance amplifier (120), and configured to acquire the voltage (VS) and to convert it into a corresponding digital output code (DS); and
- a control unit (114) coupled to the first analog-to-digital converter (112), and configured to output a calibrated measurement value (CS) obtained by applying a correction (CP) to the digital code (DS);
wherein said correction (CP) is determined by the control unit (114) as a ratio of a baseline (VB) determined at a first time instant (T0) and of a calibration value (VC) determined at a subsequent time instant (TN), the baseline (VB) and the calibration value (VC) being determined on the basis of the values of the replica resistance (124) and of the external reference resistance (128).

2. The current sensing circuit (100) of claim 1, comprising a reference current generator (116) configured to provide a reference current (IR) to the replica resistance (124), the reference current (IR) having a value determined on the basis of the reference resistance (128) and of said reference voltage (VR);
wherein the replica resistance (124) has a first terminal coupled to the reference current generator (IR) and a second terminal coupled to a ground reference (GND), and wherein the reference resistance has a first terminal coupled to the reference current generator (116) and a second terminal coupled to the ground reference (GND).

3. The current sensing circuit (100) of claim 2, further comprising a first pair of switches (S1) and a second pair of switches (S2) for selectively coupling the input port of the first analog-to-digital converter (112) either to coupling the transimpedance amplifier (120), or to the terminals of the replica resistance (124);
wherein the first pair of switches (S1) and the second pair of switches (S2) are opened or closed under the control of the control unit (114), and the control unit (114) is configured to determine said baseline value (VB), or said calibration value (VC), by commanding the opening of the first pair of switches (S1) and the closing of the second pair of switches (S2), consequently instructing said reference current generator (116) to provide the reference current (IR) to the replica resistance (124), acquiring the voltage across the replica resistance (124) by means of the first analog-to-digital converter (112), and storing the found value as calibration baseline value (VB), or as calibration value (VC), in the non-volatile memory (146).

4. The current sensing circuit (100) of claim 2, further comprising a second analog-to-digital converter (115), preferably included in the control unit (114), wherein the control unit (114) is configured to determine said baseline value (VB), or said calibration value (VC), by instructing said reference current generator (116) to provide the reference current (IR) to the replica resistance (124), acquiring the voltage across the replica resistance (124) by means of the second analog-to-digital converter (115), and storing the found value as calibration baseline value (VB), or as calibration value (VC), in the non-volatile memory (146).

5. The current sensing circuit (100) of claim 1, wherein:
- said replica resistance (124) has a first terminal coupled to said voltage reference (VR) and a second terminal; and
- said reference resistance (128) has a first terminal coupled to the second terminal of the replica resistance (124) and a second terminal coupled to the ground reference (GND).

6. The current sensing circuit (100) of claim 5, further comprising a first pair of switches (S1), a third pair of switches (S3), and a fourth pair of switches (S4) for selectively coupling the input port of the first analog-to-digital converter (112) either to the transimpedance amplifier (120), to the terminals of the replica resistance (124), or to the terminals of the reference resistance (128);
wherein the first pair of switches (S1), the third pair of switches (S3), and the fourth pair of switches (S4) are opened or closed under the control of the control unit (114), and the control unit (114) is configured to determine said baseline value (VB), or said calibration value (VC), by performing the steps of:
- commanding the opening of the first pair of switches (S1), the closing of the third pair of switches (S3), and the opening of the fourth pair of switches (S4),
- acquiring the voltage across the replica resistance (124) by means of the first analog-to-digital converter (112), and storing the found value in the system memory (144),
- commanding the opening of the third pair of switches (S3) and the closing of the fourth pair of switches (S4),
- acquiring the voltage across the reference resistance (128) by means of the first analog-to-digital converter (112), and storing the found value in the system memory (144), and
- computing the ratio of the voltage across the replica resistance (124) and of the voltage across the reference resistance (128), and storing such value as calibration baseline value (VB), or as calibration value (VC), in the non-volatile memory (146).

7. The current sensing circuit (100) of claim 5, further comprising a second analog-to-digital converter (115) having a first input port coupled to the terminals of the replica resistance (124) and a second input port coupled to the terminals of the reference resistance (128), the second analog-to-digital converter (114) being preferably included in the control unit (114);
wherein the control unit (114) is configured to determine said baseline value (VB), or said calibration value (VC), by performing the steps of:
- acquiring the voltage across the replica resistance (124) by means of the second analog-to-digital converter (115), and storing the found value in the system memory (144),
- acquiring the voltage across the reference resistance (128) by means of the second analog-to-digital converter (115), and storing the found value in the system memory (144), and
- computing the ratio of the voltage across the replica resistance (124) and of the voltage across the reference resistance (128), and storing such value as calibration baseline value (VB), or as calibration value (VC), in the non-volatile memory (146).

8. The current sensing circuit (100) of any of the previous claims, wherein:
- said transimpedance amplifier (120), said replica resistance (124), said first analog-to-digital converter (112), and said control unit (114) are integrated in an integrated circuit;
- said measurement resistance (122) and said replica resistance (124) are realized close to each other in the integrated circuit, preferably in an interdigitated structure; and
- said reference resistance (128) is provided externally to said integrated circuit, preferably as a discrete component.

9. The current sensing circuit (100) of claim 8, wherein:
- said transimpedance amplifier (120) comprises a differential amplifier (121) having a first input terminal, a second input terminal, a first output terminal, and a second output terminal;
- said measurement resistance (122) is constituted by a first measurement resistor (122a) and a second measurement resistor (122b) having substantially equal values;
- said replica resistance (124) is constituted by a series connection of a first replica resistor (124a) and a second replica resistor (124b) having substantially equal values;
- the first measurement resistor (122a) includes a first terminal coupled to the first input terminal of the differential amplifier (121) and a second terminal coupled to the first output terminal of the differential amplifier (121);
- the second measurement resistor (122b) includes a first terminal coupled to the second input terminal of the differential amplifier (121) and a second terminal coupled to the second output terminal of the differential amplifier (121).

10. The current sensing circuit (100) of any of the previous claims, wherein said reference resistance (128) has a resistance value substantially equal to the initial (T0) value of the measurement resistance (122).

11. A method (200, 250) for measuring a current (IS) by means of a current sensing circuit (100) according to claims 1 to 10, comprising performing the steps of:
- acquiring (201; 251) at a first time instant (T0) through an analog-to-digital converter (112; 115) a calibration baseline value (VB) indicative of a ratio between the replica resistance (124) and the reference resistance (128), associating to the calibration baseline value (VB) a timestamp value (TZ) indicative of the time at which the calibration is performed, and storing said calibration baseline value (VB) and said timestamp value (TZ) in a non-volatile memory (146);
- determining (202; 252), at a subsequent time instant (TN), whether a new calibration is required on the basis of said timestamp value (TZ);
- in response to determining that a new calibration is required, performing (203; 253) a further calibration measurement (VC), updating the value of the timestamp (TZ) to the time at which the new calibration is carried out, and computing the value of a calibration parameter (CP) as a ratio of said calibration baseline (VB) and of the calibration measurement (VC);
- measuring (204; 254) the input current (IS) through the transimpedance amplifier (120) and the analog-to-digital converter (112) coupled thereto, returning a digital code (DS) indicative of the measured input current (IS);
- applying (205; 255) in the control unit (114) a correction to the digital code (DS) based on the calibration parameter (CP) stored in the non-volatile memory (146), returning a calibrated measurement (CS).
